# EUROPEAN PATENT SPECIFICATION

(11) **EP 0 805 453 B1**
(45) Date of publication and mention of the grant of the patent: **02.01.2004**
(21) Application number: 96830239.8
(22) Date of filing: 29.04.1996
(51) Int. Cl.: G11C 7/00

(54) **Memory architecture for flexible reading management, particularly for non-volatile memories, having noise-immunity features, matching device performance, and having optimized throughput**
Speicherarchitektur für flexibele Leseverwaltung, insbesondere für nichtflüchtige Speicher, mit Rauschunempfindlichkeitsmerkmalen, mit Anlageleistungsanpassung und mit optimiertem Durchfluss
Architecture de mémoire pour gestion de lecture flexible, spécialement pour des mémoires non volatiles, avec des caractéristiques d'immunité au bruit, correspondante à la performance du dispositif, et avec débit optimisé

(43) Date of publication of application: 05.11.1997
(73) Proprietor: STMicroelectronics S.r.l., 20041 Agrate Brianza (Milano) (IT)
(72) Inventor: Pascucci, Luigi, 20099 Sesto San Giovanni (Milano) (IT)
(74) Representative: Modiano, Guido, Dr.-Ing.

(56) References cited:
- EP-A- 0 186 906
- EP-A- 0 301 603
- EP-A- 0 473 127
- EP-A- 0 526 433
- GB-A- 2 261 089

## Description

The present invention relates to a memory architecture for flexible reading management, particularly for non-volatile memories, having noise-immunity features, matching device performance, and having optimized throughput. In particular, the invention relates to a memory architecture that is capable of ensuring correct reading of said memory with improved performance with respect to conventional architecture.

In fast parallel memories, one of the most challenging problems is the error of a generic read operation caused by any source of noise, whether internal to the memory device or caused by the memory itself during the switching of its output buffers.

This problem worsens as the degree of parallelism (x8, x16, x32...) increases and as the required transition speed rises.

Switchings on the outputs, in addition to generating intense noise on the internal circuits of the memory, generally slow down the reading times; the less synchronously this event occurs and the greater the number of outputs, the greater the slowing effect.

Accordingly, memories with a plurality of outputs are the most vulnerable ones as regards noise, and it is difficult to improve their speed performance.

A possible answer to this problem is constituted by a design approach with so-called time-controlled architectures, in which a time is set during which reading must be performed.

However, this solution has further problems. First of all, there is the drawback of the difficulty in achieving correct reading at power supply start-up, i.e., when the power supply has not yet reached its steady-state value.

In a time-controlled or sampled system, once a reading operation has been performed, it cannot be changed until the next reading operation occurs.

Furthermore, this second type of memory architecture does not have the necessary features of flexibility and adaptability to the various conditions of the devices of the memory and to the different power supply conditions. The adoption of a rigid architecture does not combine well with the indispensable requirement of matching the conditions and properties of the devices and circuits and with the need to optimize the reading speed in every circumstance while preserving its correctness.

This entails the need to determine preset delays to ensure reading correctness; these delays must also be long enough to be sure of having correct reading in all possible operating situations and with devices having different characteristics; however, the problem of first reading is still not solved.

The lack of flexibility and adaptability makes it difficult to use these architectures if the technology used in the memory changes, unless one radically modifies the circuital structure of the architecture to adapt to the new requirements.

Further drawbacks are caused by the consumption of the memory circuits and by reliability problems, caused by the fact that the read circuits are constantly biased.

EP-0 526 433 discloses a memory architecture as defined in the preamble of claim 1.

EP-0 145 488 discloses a circuit for enabling the reading process of a memory in response to an output signal of a dummy precharge circuit simulating characteristics of circuits elements contained in the memory.

The aim of the present invention is therefore to provide a memory architecture for flexible reading management, particularly for non-volatile memories, that allows to provide a memory read path management that is controlled digitally and is synchronized in its natural development.

Within the scope of this aim, an object of the present invention is to provide a memory architecture for flexible reading management, particularly for non-volatile memories, that allows to flexibly link reading to the characteristics of the devices used, to the various temperature and power supply conditions that occur, and to the state of the technology.

Another object of the present invention is to provide a memory architecture for flexible reading management that allows to ensure correlation of the reading timing with the propagation conditions of the word lines and of the bit lines.

Another object of the present invention is to provide a memory architecture for flexible reading management, particularly for non-volatile memories, that allows to perform correct reading in assured conditions from the very start, even during power supply start-up.

Another object of the present invention is to provide a memory architecture for flexible reading management, particularly for non-volatile memories, that allows to minimize memory consumption.

Another object of the present invention is to provide a memory architecture for flexible reading management, particularly for non-volatile memories, that immediately presets, after the end of a reading operation, the initial conditions, disabling all word lines and eliminating any consumption linked to the reading structures.

Another object of the present invention is to provide a memory architecture for flexible reading management, particularly for non-volatile memories, that interrupts any consumption from the boost line.

Another object of the present invention is to provide a memory architecture for flexible reading management, particularly for non-volatile memories, that allows to reduce the output buffer switching time.

Another object of the present invention is to provide a memory architecture for flexible reading management, particularly for non-volatile memories, that eliminates false readings and allows a substantial filtering of noise, so as to always correctly read the data contained in said memory.

Another object of the present invention is to provide a memory architecture for flexible reading management, particularly for non-volatile memories, that allows to handle in a time-controlled manner the various events that constitute a reading step, so as to synchronize their occurrence.

Another object of the present invention is to provide a memory architecture for flexible reading management, particularly for non-volatile memories, that allows to control boost circuits, if provided.

Another object of the present invention is to provide a memory architecture for flexible reading management, particularly for non-volatile memories, that allows to provide the possibility of selecting byte-type or word-type reading mode.

Another object of the present invention is to provide a memory architecture for flexible reading management, particularly for non-volatile memories, that disables any static biasing conditions within the matrix of the memory device.

Another object of the present invention is to provide a memory architecture that is highly reliable, relatively easy to manufacture, and at competitive costs.

This aim, these objects, and others that will become apparent hereinafter are achieved by a memory architecture for flexible reading management, particularly for non-volatile memories, as defined in claim 1.

This aim, these objects, and others that will become apparent hereinafter are also achieved by a method for reading data of a memory device, particularly of the non-volatile type, as defined in claim 14.

Further characteristics and advantages of the invention will become apparent from the description of a preferred but not exclusive embodiment of the device according to the invention, illustrated only by way of non-limitative example in the accompanying drawings, wherein:
figure 1 is a block diagram of the memory architecture according to the invention, in the case of a single memory matrix;
figure 2 is a block diagram of the memory architecture according to the invention, in the case of a memory provided with two memory matrices;
figure 3 is a circuit diagram of a portion of the block diagram of figures 1 and 2;
figure 4 is a circuit diagram of a portion of the block diagram of figures 1 and 2;
figure 5 is a circuit diagram of a portion of the block diagram of figures 1 and 2;
figure 6 is a circuit diagram of a portion of the block diagram of figures 1 and 2; figure 7 is a chart of the timings of the various signals that are present in the memory architecture according to the invention;
figure 8 is a chart of the timings of the various signals that are present in the architecture according to the invention, illustrating the correlation with the supply voltage in the absence of a boost voltage; and
figure 9 is a chart of the timings of the various signals that are present in the architecture according to the invention, illustrating the correlation with the supply voltage in the presence of a boost voltage.

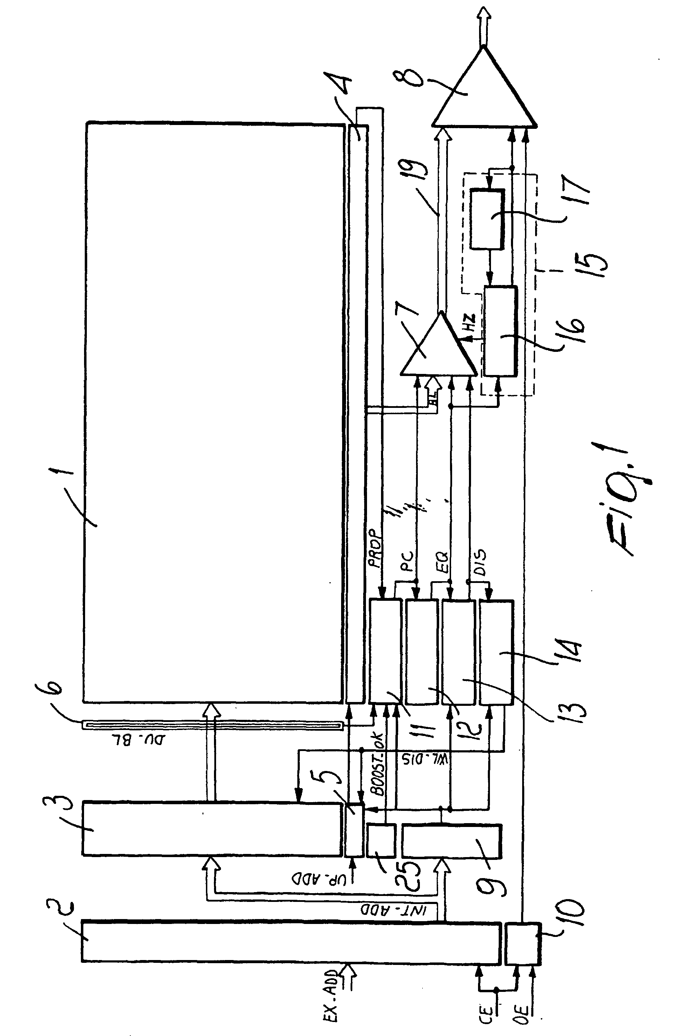

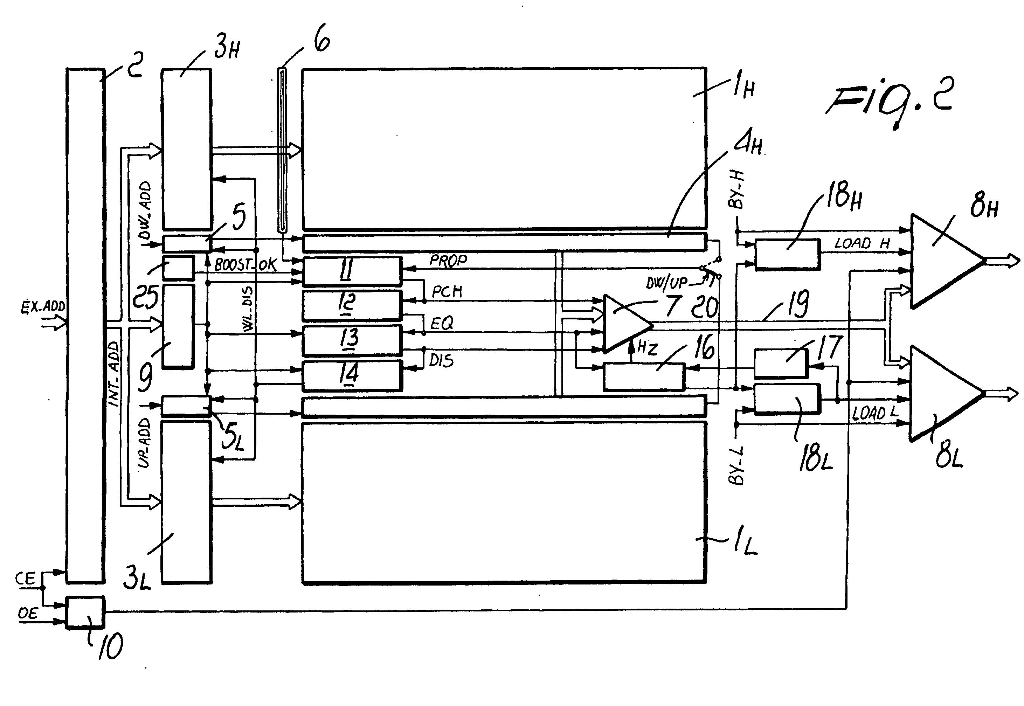

With reference to the above figures, and particularly initially to figures 1 and 2, the architecture according to the invention comprises: at least one memory matrix 1, which is divided into a plurality of word lines and bit lines and is provided with a dummy reference word line 4 to reproduce propagation along a generic word line; an address buffer 2, which receives in input the read addresses carried by an external address bus EX-ADD; a row decoder 3 for selecting a row of the memory matrix 1 and a decoder 5 for stimulating propagation along the dummy word line 4, driven by a signal designated by UP-ADD; a dummy bit line 6 to reproduce the pre-charge over a generic bit line of the matrix 1; a plurality of sense amplifiers 7 (one for each bit of the memory matrix: in case of an 8-bit memory, therefore, eight sense amplifiers plus one for the redundancy lines) to capture the data from the matrix 1; a plurality of output buffers 8, whose number is equal to the number of sense amplifiers 7; and reading timing control circuits that will be described in detail hereinafter.

Each one of the output buffers 8 is provided with a memory structure that allows to disconnect them from the rest of the circuit and to update their content only at the end of a complete reading operation, thus preventing any unwanted propagation induced by noise.

Thanks to substantial noise-immunity, the output buffers 8 are provided with much larger physical dimensions than the output buffers of conventional architecture, with a considerable reduction of switching times, consequently providing faster reading.

The address buffer 2 is connected, by means of an internal address bus INT-ADD, to the row decoder 3 and to a circuit 9 for generating a pulsed signal ATD (Address Transition Detection) for detecting the transition of a read address of the memory matrix 1.

The decoder 5, the dummy bit line 6, and the dummy word line 4 constitute a propagation reproduction structure that when stimulated at the end of the pulse of ATD allows to repeat the propagation of the word line and of the bit line that have actually been selected, in order to assuredly and synchronously determine the timing with which a successful reading operation of the memory device must be triggered.

The row decoder 3 is advantageously constituted, for example, by a decoder of the hierarchical type.

A circuit 10 for activating the output buffers 8 receives in input a memory device enable signal CE, which is also sent in input to the address buffer 2, and an output enable signal OE to activate the output buffers 8 only at the end of a completed reading cycle, thus reducing, from the very first reading cycle, the possibility of generating noise and therefore preventing the consequent increase in the access time of a first reading cycle.

The output activation circuit 10 is described in EPA No. 94830538.8, in the name of the same Applicant as the present application, which is assumed included herein as reference.

The sense amplifiers 7 are connected to the output buffers 8·by means of an internal bus 19 for the output transfer of the data captured by the memory matrix 1.

The internal bus 9 is described in detail in EPA no. 96830128.3, EPA no. 96830129.1, and EPA no. 96830127.5 in the name of the same Applicant as the present application, which are assumed included herein as reference.

The above mentioned read timing control circuits comprise, in addition to the circuit 9 for generating the signal ATD:
-- a set of circuits, generally designated by the reference numeral 11 and shown merely in block form, adapted to enable a process for reading the memory matrix 1 only when the minimum functionality levels of the memory cells involved in the reading operation and of all the connected read circuits have been reached. These circuits 11 ensure correct reading even during power supply transitions, i.e., when the power supply has not yet reached its steady-state value;
-- an equalization and linking network 12, adapted to equalize the bit lines involved in the reading operation and to link said equalization to the characteristics of the memory devices and to the supply conditions. Said network 12 makes the reading cycle flexible, adapting it, without any reconfiguration, to the different operating conditions (low voltage, boost voltage, etcetera), to the real conductivity of the matrix cells, and to the propagations of the signals. The network 12 emits in output an equalization signal EQ that is sent in input to a circuit 13 for enabling/disabling the read circuits and to the sense amplifiers 7;
-- a circuit 13 for enabling/disabling the read circuits, which allows to enable the read circuits only at the end of the pulse of ATD and exclusively for the time required for reading, thus limiting the consumption of the memory device to this single step;
-- a cycle end circuit 14 and a line WL-dis for deactivating/activating the row decoding performed by the decoder 3 and the decoding of the decoder 5. The circuit 14 allows to enable the row decoder 3 synchronously with the arrival of the pulsed signal of ATD and determines its deactivation upon capture of the data item read in the corresponding sense amplifier 7 in parallel to the transfer of said data item on the corresponding output buffer 8; in this manner, one eliminates any possible consumption due to decoding, avoids maintaining useless biasings of the cells of the matrix 1, and eliminates the consumptions related to the decoder 3, which mainly involve the boost structure.

The circuit 13 thus emits a signal DIS that is sent to the sense amplifiers 7 and to the cycle end circuit 14; and
-- a loading pulse generating circuit 15 (not shown in detail, described in EPA no. 96830169.7 in the name of the same Applicant as the present invention, and assumed included herein as reference) for the synchronized loading of the data in the output buffers 8, the duration of the loading operation being limited to the time interval that is sufficient for the transit and capture of the data in the memory structure of the output buffers 8.

The circuits 11, 13, and 14 are driven by the signal ATD; i.e., their operation is synchronized with the falling edge of the signal ATD.

In greater detail, the circuits 11 comprise a structure (not shown) for reproducing the operating conditions within the memory matrix; said structure comprises in turn:
-- a circuit for reproducing the propagations along a generic word line (not shown, described in EPA no. 96830160.6 in the name of the same Applicant as the present application, and assumed included herein as reference);
-- a circuit for reproducing the selection/deselection and pre-charge delays of a generic bit line (not shown in detail, described in EPA no. 96830197.8 in the name of the same Applicant as the present application, and assumed included herein as reference); and
-- a circuit for determining when the working point of the bit line involved in the reading operation is attained (not shown, described in EPA no. 96830197.8 in the name of the same Applicant as the present application, and assumed included herein as reference).

The circuit for reproducing the propagations along a generic word line produces the signal PROP, which is used, together with a signal for reproducing the selection/deselection and pre-charge delays of the bit line, to generate a signal that is adapted to interrupt the precharge of the bit line so as to closely match the attainment of the minimum-functionality conditions of the memory cells and of the read circuits.

If the minimum-functionality conditions are not reached, the system remains in pre-charge mode until said conditions occur.

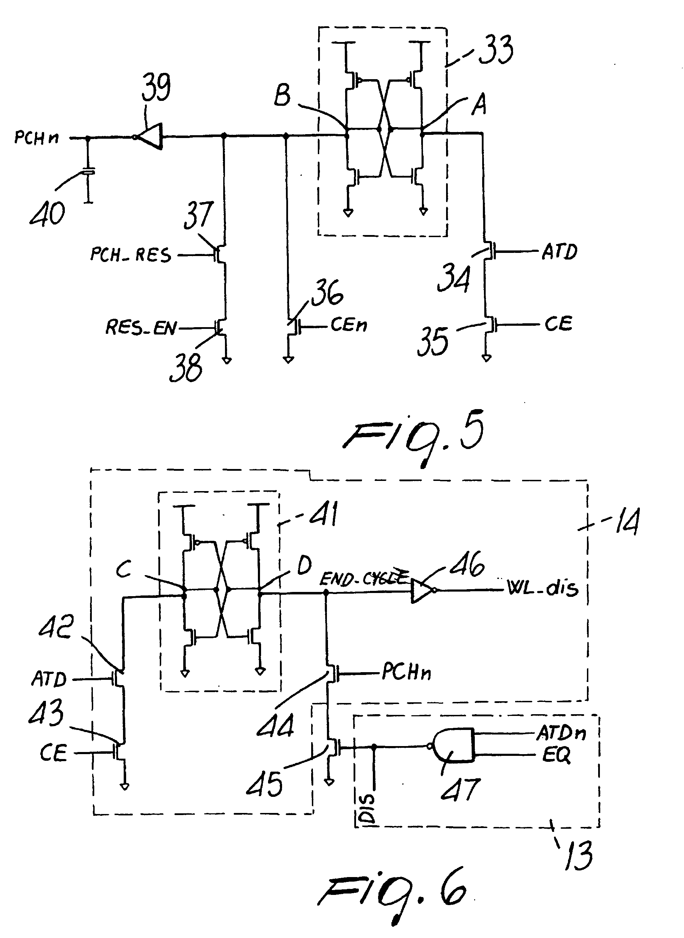

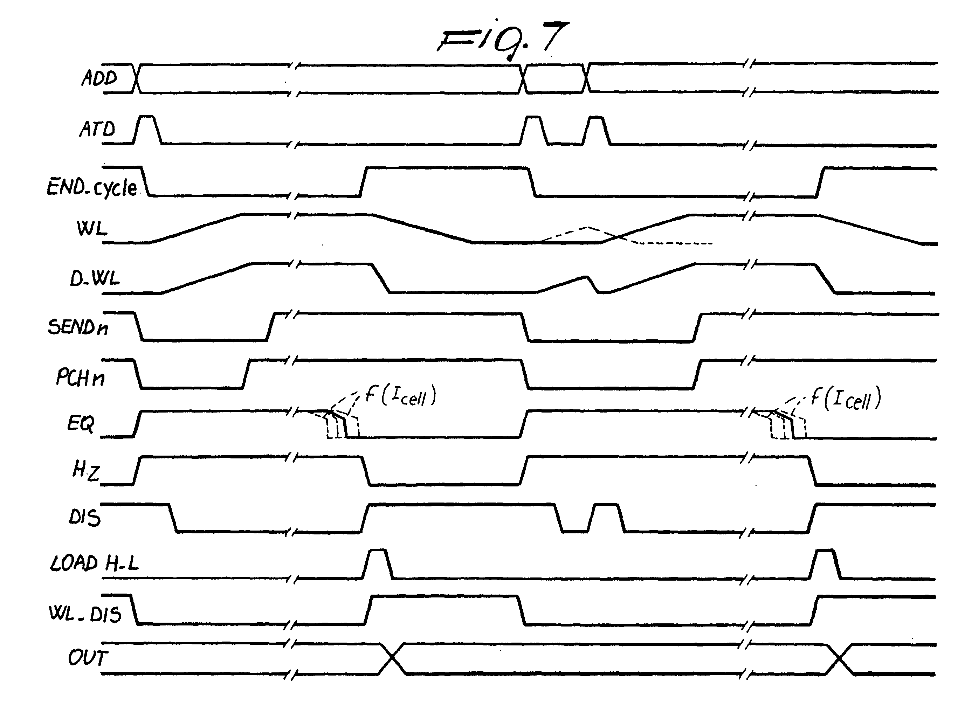

The circuit for determining working point attainment produces the pre-charge step interruption signal to allow to proceed with data reading. This signal is referenced by PCH-RES in figure 5.

The circuits 11 also comprise a circuit (not shown in detail) for generating a power-on reset signal (POR signal), which includes a memory cell that is fully identical to a generic memory cell of the memory matrix 1. Said circuit for generating the signal POR is correlated to the minimum detectable conductivity level reached by the reference memory cell and therefore triggers reading timing only when said POR signal becomes low.

The circuit for generating the POR signal is described in detail in EPA no. 96830046.7 in the name of the same Applicant as the present application, assumed included herein as reference.

The circuits 11 also comprise a memory circuit for the pre-charge step (shown in detail in figure 5) that is adapted to determine, at the onset of the minimum-functionality conditions, the end of the pre-charge step to perform a first correct reading of the memory cells in assured conditions. The signal emitted by the memory circuit for the pre-charge step is referenced by PCHn in figure 5.

The circuits 11 then emit a pre-charge signal PCH that is sent to the equalization and linking network 12, which allows to modulate the delay and duration of the subsequent equalization step in close correlation with the conductivity of a reference memory cell that is fully identical to a memory cell of the memory matrix 1.

The time interval of the equalization step is also flexible, depending on the conductivity characteristics of the non-volatile elements (memory cells), on their biasing conditions, and on the temperature.

The pre-charge signal PCH is also sent to the sense amplifiers 7.

The equalization and linking network 12 is described in EPA no. 96830165.5, which is in turn correlated with EPA no. 96830168.9.

The operation of the circuits 11 is correlated with the power supply conditions that are currently present in the memory device, i.e., a voltage V_{DD} or a boost voltage.

The linking to the supply voltage allows to determine a minimum pre-charge interval that matches the supply voltage that is actually present; in this manner, the reading timing is determined flexibly, without altering the configuration of the read circuits if the operating conditions or the technology changes.

If a boost voltage is present, the reading timing, in its first cycle, if it has started in a transient step, must be slowed down in order to allow the boost voltage to reach the preset minimum level. If this does not occur, use of the boost voltage would be useless.

For this purpose, there is a circuit 25 (not shown in detail) for determining when a threshold voltage is reached by the boost voltage; said circuit emits in output a signal BOOSTok adapted to trigger the reading process. The signal BOOSTok is sent in input to the circuits 11.

Thus, the pre-charge step is synchronized with the attainment of the minimum detectable conductivity conditions.

The circuit 25 for determining when the boost voltage reaches a threshold voltage is described in EPA no. 9583030360.4 in the name of the same Applicant as the present invention and is assumed included herein as reference. Figure 4 illustrates a logic circuit that receives in input a signal setBOOST indicating the presence of the boost voltage and the signal BOOSTdet that indicates that the threshold for the boost voltage has been exceeded, in order to emit the signal BOOSTok in output.

This circuit determines, by virtue of a comparison with a substantially constant reference voltage, whether the voltage to be monitored, in this case the boost voltage, which can vary between a first value and a second value, exceeds a preset threshold. This evaluation is performed by subtraction between the reference voltage and the voltage to be monitored.

If the signal setBOOST is low, then said function is disabled and the signal BOOSTok is produced, with an appropriate delay, at the end of the POR signal, by virtue of delPORn.

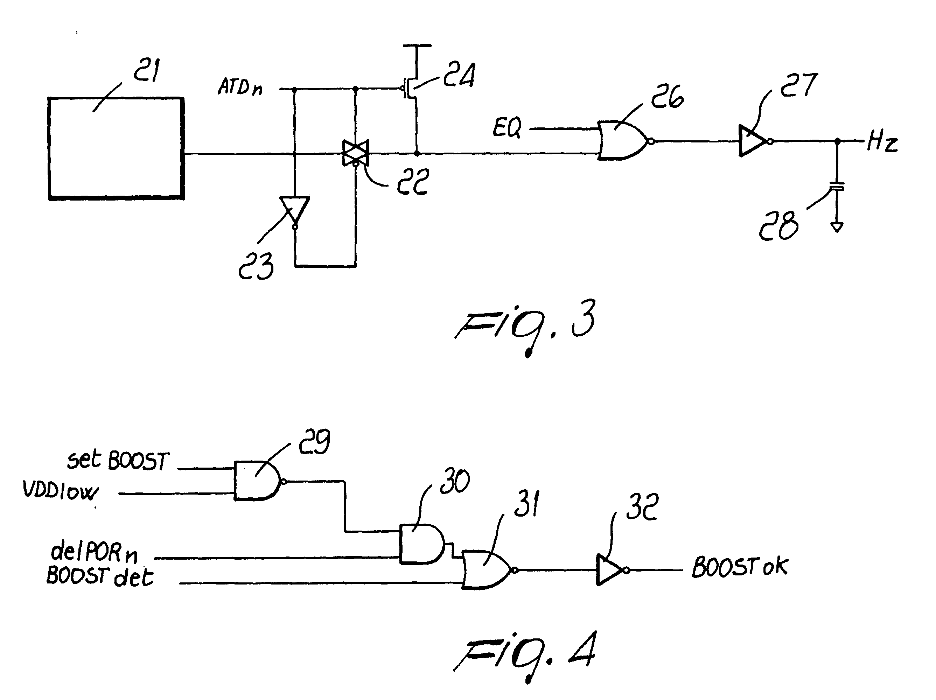

The circuit 15 for the synchronized loading of the data in the output buffers 8 comprises a circuit 16 for generating a signal Hz and a signal for loading the data in the output buffers 8 (said circuit is shown in detail in figure 3) and a circuit 17 for restoring the signal Hz.

Figure 2 shows the memory architecture according to the invention, in the case in which the memory matrix 1 is split into two half-matrices, designated respectively by 1_{H} and 1_{L}.

In figure 2, the elements that correspond to the ones present in figure 1 are designated by the same reference numerals. In order to distinguish the elements provided for the half-matrix 1_{H} and for the half-matrix 1_{L}, the reference numerals are given a suffix "H" or "L" that indicates that the designated element relates to one or the other of the two half-matrices.

Figure 2 shows that only one dummy bit line 6 is still provided even in the case of two half-matrices 1_{H} and 1_{L}.

As regards the decoder 5, now there are two decoders 5_{H} and 5_{L}, driven respectively by a signal DW-ADD and by a signal UP-ADD. The decoder 5_{H} stimulates the dummy word line 4_{H} when a read address is produced for the opposite half-matrix, i.e., the half-matrix 1_{L}. The dummy word line 4_{H} is stimulated in the opposite case.

Selection of one or the other of the dummy word lines 4_{H} and 4_{L} is determined by a signal DW/UP that indicates stimulation of the line 4_{H} or of the line 4_{L}. Said signal acts on a switch 20.

The data loading circuit 15 shown in figure 1 also comprises, in the case of the two half-matrices of figure 2, circuits 18_{L}, 18_{H} for selecting the byte or word reading mode. These circuits allow to select the synchronized loading of data from one or the other of the memory half-matrices and are controlled respectively by the signals BY-L and BY-H.

Figure 3 shows in detail a possible circuital implementation of a circuit for generating a synchronization signal Hz that is adapted to enable, when low, the loading of the data from the sense amplifier 7 on the internal bus 19, in correlation with the presence of the signal ATD and of the equalization signal EQ.

Said circuit comprises means 21 for enabling the generation of the signal Hz that are output-connected to a pair of pass transistors 22 that is formed by a P-type transistor and by an N-type transistor.

The signal ATD generated by the circuit 9, appropriately inverted (ATDn), is sent in input to the gate terminal of the N-type transistor of the two pass transistors 21 and is also sent in input, after passing through an inverter 23, to the gate terminal of the P-type transistor of the same pair 22 of pass transistors.

The signal ATDn is also sent in input to a P-type transistor 24 that is interposed between the supply voltage and the output of the pair of pass transistors 22.

A NOR logic gate 26 receives in input the output of the pair of pass transistors 22 and the equalization signal EQ.

An inverter 27 is cascade-connected to the NOR gate 26 and its output is discharged to the ground across a capacitor 18. The output of the inverter 27 is the signal Hz for enabling the loading of the data from the sense amplifier to the internal bus 19.

Figure 4 shows, in circuital detail, the circuit for generating the signal BOOSTok. The circuit comprises a first NAND gate that receives in input the signal setBOOST, which indicates that a boost voltage is used, and the signal VDDlow, which indicates that the supply voltage used in the device is low (hence the need to use a boost voltage).

The output of the NAND gate 29 is sent in input to an AND gate 30, whose other input is constituted by the signal delPORn. The output of the AND gate 30 is sent in input to a NOR gate 31, whose other input is constituted by the signal BOOSTdet, which indicates that the boost voltage has reached the desired threshold level.

The output of the NOR gate 31 is sent in input to an inverter 32 whose output is the signal BOOSTok, which is adapted to trigger the reading process.

Figure 5 is a detail view of the memory circuit for the pre-charge step, defined in figure 1, together with other above described circuits, in the block designated by the reference numeral 11.

Said circuit comprises a memory structure of the flip-flop type 33, which has an input node A and an output node B.

A first control branch is connected to the input node A and is constituted by the series-connected N-channel transistors 34 and 35, which respectively receive, at their gate terminals, the signal ATD and the signal CE.

A second control branch is connected in output to the node B and is constituted by the N-channel transistor 36, which receives the signal CEn in input at the gate terminal.

A third control branch is parallel-connected to the second control branch and is constituted by an N-channel transistor 37 and by an N-channel transistor 38 that are series-connected and respectively receive in input, at their gate terminals, the pre-charge step interruption signal PCH-RES and the signal RES-EN.

These two signals are generated by the circuits of the block 11 of figure 1.

An inverter 39 is cascade-connected to the third control branch, and its output is connected to the ground by means of a capacitor 40. The output of the inverter 39 is the signal PCHn, which determines the end of the pre-charge step to start the subsequent equalization step.

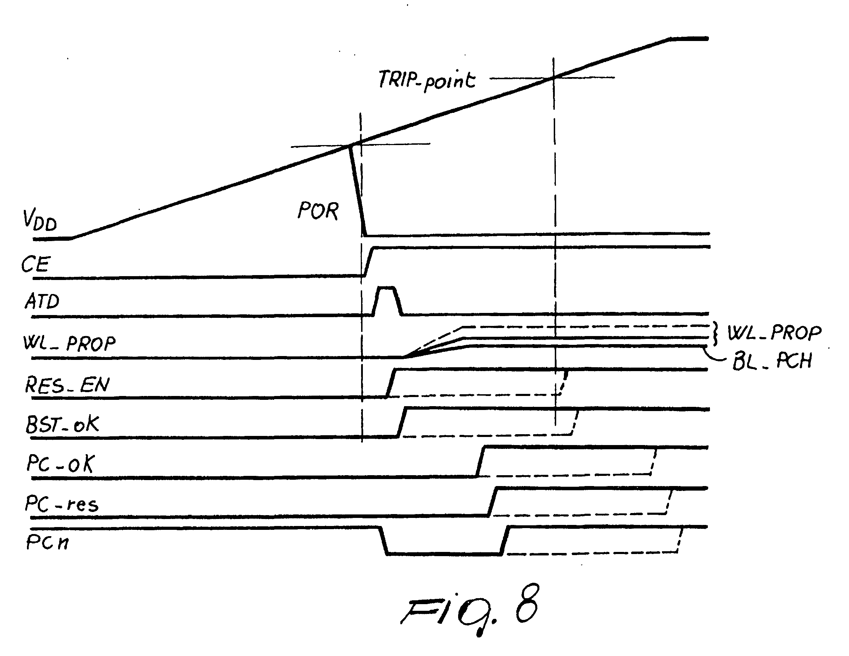

Figure 6 illustrates, in its circ uital details, the circuit 13 for enabling/disabling the read circuits, the read cycle end circuit 14, and the line WL-dis for deactivating/activating row decoding.

The circuit 13 comprises a memory structure that is constituted by a flip-flop 41 that has an input node C and an output node D.

A first circuit branch is connected to the node C and comprises two series-connected N-channel transistors 42 and 43 that receive the signals ATD and CE, respectively, at their gate terminals.

A second circuit branch is connected to the output node D and is constituted by two series-connected N-channel transistors 44 and 45 that receive in input to their gate terminals the signals PCHn (generated by the circuit of figure 5) and DIS (for enabling/disabling the read circuits) respectively. The signal DIS is generated by a NAND gate 47, whose inputs are the signals ATDn and EQ.

An inverter 46 is cascade-connected to the output node D and its output is the signal WL-dis for disabling the word line.

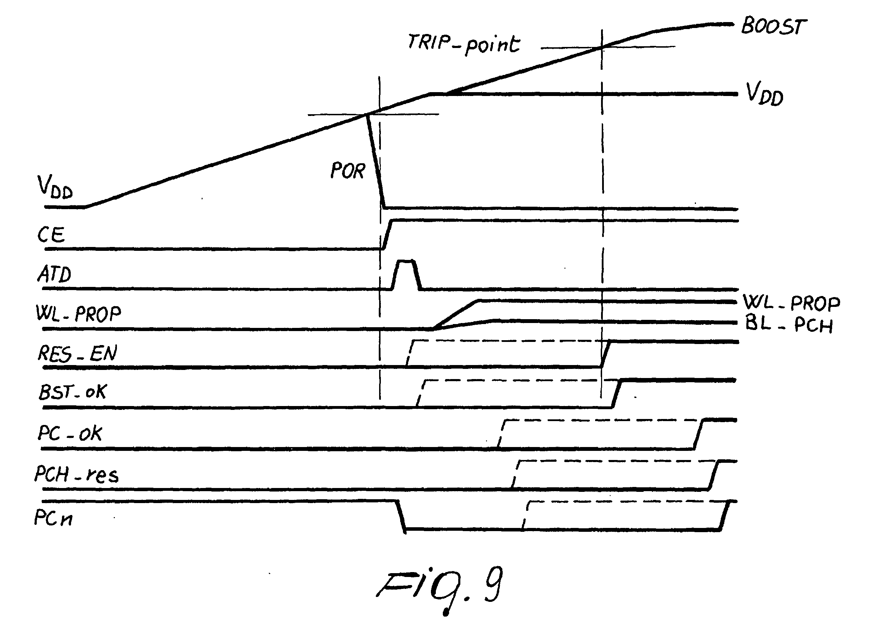

Figures 7, 8, and 9 are charts of the timings of the various signals that are present in the memory device and will be explained hereinafter with reference to the operation of the memory architecture according to the invention.

With reference to the above figures, the operation of the memory architecture according to the invention is as follows.

For the sake of simplicity, the operation of the architecture according to the invention will be explained in relation to the case of a single memory matrix, as shown in figure 1.

A signal CE (Chip Enable) for enabling the device enables the address buffer 2, and a memory read address is provided by the address bus EX-ADD to the address buffer 2 and is sent from there, by means of the bus INT-ADD, to the row decoder 3, which selects the word line addressed in the memory matrix 1.

When the output enable signal OE (Output Enable) is present, the enable signal CE also enables the enable circuit 10 of the output buffers 8. The signal OE is generated only at the end of a completed read cycle, thus limiting the possibility of generating noise that can alter the data in the output buffer 8, and therefore prevents extension of the access time of a first read cycle.

The read address is also sent to the circuit 25 for generating the address transition detection signal ATD, which synchronizes the operation of all the downstream read circuits, thus correlating all subsequent timings with the actual detection of the read address transition.

The correlation of the generation of the signal ATD with the transition of the address ADD is shown in the chart of figure 7, to which reference will be made hereinafter to show the development of the various signals of the memory device.

The signal END-cycle, in this step (at the end of the signal ATD), is low, so as to enable the row decoder 3.

The signal ATD is sent in input to the circuits 11, 13, and 14.

If a boost voltage is provided as a supply voltage for the memory device, the circuit 25 determines the attainment of a threshold voltage on the part of the boost voltage and emits in output the signal BOOSTok for enabling memory reading.

The circuit 25 is shown in figure 4 (said figure does not show the circuit that is adapted to determine whether the boost voltage has exceeded the threshold voltage and emits in output the signal BOOSTdet); in this figure, if the signal setBOOST that indicates the setting of the boost voltage is high and the signal VDDlow is also high, i.e., the supply voltage V_{DD} is low (hence the need for the boost voltage), then the output of the NAND gate 29 is high. If the signal delPORn is high, the output of the AND gate 30 is high. When the signal BOOSTdet is high, the output of the NOR gate 31 is low and the output of the inverter 32 is therefore high, i.e., the signal BOOSTok is high.

If the signal setBOOST is low, then the signal BOOSTok is still produced, by means of the signal delPORn, with delay by the POR pulse.

Said signal is sent in input, together with the signal ATD, to the circuit 11 for determining whether the minimum functionality conditions of the read circuits have been attained.

The circuit 11 receives in input the signal PROP for reproducing the propagation on the dummy word line 4 and a signal for reproducing the propagation on the dummy bit line 6, so as to assuredly detect the starting time of correct reading.

The circuit 11 determines the pre-charge signal PCH, which is adapted to determine the end of the pre-charge interval, in correlation with the generation of the POR signal, which determines the timing at which the supply voltage has reached a value that ensures correct reading (thus solving the problem of the first reading of a memory device after power supply start-up, regardless of the rising slope of said power supply), and also in correlation with the signal PROP and with the signal for reproducing propagation along the dummy bit line 6.

After determining a minimum pre-charge interval that is correlated to the characteristics of the devices and to the supply voltage, on the basis of which the signal PCH-RES that indicates interruption of the pre-charge step is generated, and in correlation with the signals ATD, CE, CEn, and RES-EN, the signal indicating the end of the pre-charge step PCH is generated (in the case of the circuit of figure 5, which shows the memory circuit for the pre-charge step, the generated signal is the inverted pre-charge signal PCHn).

Said signal is sent to the network 12, which determines the equalization signal EQ that matches the operating conditions of the devices (low voltage, boost voltage, etcetera), the real conductivity of the memory cells involved in the reading operation, and the propagations of the signals along the lines of the memory matrix.

Said signal EQ is then "modulated" as a function of the actual current conditions of the devices.

In greater detail, the lower the conductivity of the memory cells, the longer the data evaluation time delay and the slower the execution of said evaluation. Vice versa, the higher the conductivity, the earlier the evaluation step and the faster the data capture.

Timing is therefore flexible and linked to the actual propagations of the non-volatile cells in their real context.

At low voltages, therefore, said equalization signal EQ is longer but may be reduced significantly if a boost structure is active in the device and improves the conductivity of the cells by raising the voltage applied to the word lines.

The equalization signal EQ determines, by virtue of its development, the end of the equalization step and is sent in input to the read circuit enabling/disabling circuit 13, to the sense amplifiers 7, and to the circuit 16 for generating the signal Hz.

During this initial step, as shown in figure 7, the signal Hz is high to prevent access of the data from the sense amplifiers 7 to the internal bus 19.

The signal WL of figure 7 indicates the onset of propagation on the selected word line, and the signal D-WL indicates reproduction of the propagation of said word line, performed by means of the dummy word line 4.

If a memory matrix 1 split into two half-matrices 1_{L} and 1_{H} is used, propagation reproduction occurs asymmetrically in the half-matrix that is opposite to the one in which the actual word line is selected.

The signal SENDn is an additional signal that allows to send internal data of the memory over the internal bus 19, when said bus is not used by the read circuits meant to read the data of the memory. During this step, SENDn is low.

The signal DIS generated by the circuit 13 during this step is low, so as to enable the read circuits only for the time required for reading, thus limiting to this step alone the corresponding consumption and the biasing of a generic word line. The high state of the signal DIS interrupts all consumption of the read circuits.

The signal DIS remains low (indicating enabling) throughout the period in which the signal EQ is high and the signal Hz is high.

The signal DIS is sent in input to the cycle end circuit 14 and to the sense amplifiers.

The cycle end circuit 14 generates the signal WL-dis for enabling/disabling row decoding both for the actual word line and for the dummy word line 4.

The dummy lines 4 and 6 have asymmetrical characteristics: they are fast during resetting and instead behave according to native propagations during the activation step. This feature is useful to repeat internal propagations and at the same time to quickly restore the initial conditions without adding further lines.

During this step, therefore, the signal WL-dis is low, enabling decoding.

The signal LOAD H-L is instead the signal for enabling/disabling the loading of the data of the matrix 1 in the output buffers; said signal is still low during this step, preventing the loading of the data in the output buffers 8. In the case of a byte-only module, there is a single control signal, whereas when WORD/BYTE configuration is possible there are two control lines: LOAD H indicates loading of the data of the "high half-word" (half-matrix 1_{H}) and the signal LOAD L indicates loading of the data of the "low half-word" (half-matrix 1_{L}).

The circuit of figure 3 illustrates the generation of the signal Hz in correlation with ATDn and EQ.

The pre-charge signal PCHn is correlated with the propagation of the word line WL and with the pre-charge of the dummy bit line 6, both of which are stimulated at the end of the signal ATD. Therefore, PCHn becomes high only when the propagations on the word and bit lines have reached the working level. At this point, the signal PCHn remains high up to the following pulse of ATD, which indicates a new address transition.

The signal PCHn is generated by the memory circuit for the pre-charge step, shown in figure 5.

The signal OUT shown in figure 7 determines the switching of the output buffers 8 as a consequence of the loading of the data therein; this loading, as shown, is timed by the signal LOAD H-L.

Therefore, when the signals on the word line have propagated, when the signal EQ becomes low, the signal Hz becomes low ( enabling access to the internal bus 19 on the part of the data of the memory), the signal DIS becomes high, and the signal WL-dis also becomes high to disable decoding; then the signal LOAD H-L undergoes a very short pulsed transition that corresponds to the transit and storage time of the data in the output buffers 8.

The generation of the signal WL-dis is shown in figure 6 in correlation with the signals ATD, CE, PCHn, ATDn, and EQ.

Storage of the data in the output buffers 8 then allows to disconnect said output buffers from the rest of the circuit (returning the signal LOAD L-H to a low value and disabling the output buffers by means of the low signal OE), so as to prevent noise from causing unwanted switchings of said output buffers, thus corrupting the data.

The signal END-cycle switches to the high level simultaneously with the switching of the signals DIS, WL-dis, and LOAD H-L to the high level, determining the end of the read cycle and thus also the end of the consumptions of the read paths (including the boost voltage).

Let us now consider the case in which there are two very close pulses of ATD, as shown in figure 7.

In this case, the propagation of the word line WL and therefore of the dummy word line 4, D-WL, are interrupted by the arrival of the second pulse of ATD before the propagations can occur completely.

If the propagations are incomplete, the signals PCHn and EQ, correlated to said propagations, do not switch to the high and low levels respectively, but extend their duration and then switch when full propagations are actually achieved.

In these contexts, the "fast reset" feature of the dummy lines 4 and 6 is advantageous.

Therefore, an incomplete read cycle does not allow to update the content of the output buffers 8, since the signal LOAD H-L is generated only when EQ and Hz switch to the low level.

The modulation of the start time (i.e, the delay) of the switching of the signal EQ and of the slope of said signal, correlated to the conductivity of the memory cells involved in the reading operation, allows to determine an extremely flexible equalization step.

In this manner, the reading timing is dynamically linked to the operating conditions, to the conductivity and to the characteristics of the devices determined by the technology that is used.

The signals Hz, DIS, LOAD H-L, WL-dis, and OUT are correlated to the development of the equalization signal EQ.

Figures 8 and 9 are useful in showing the developments of the signals that are present in the architecture according to the invention. In particular, it can be seen that as the supply voltage V_{DD} rises, in the case of no boost voltage (figure 8), the developments of the signals are determined on the chart by the solid lines. If the boost voltage is present, instead (figure 9), the developments of the signals are shifted (i.e., the dashed lines now show the development in case of no boost voltage and the solid lines indicate development in case of boost voltage), since the reading timing waits for trip point attainment, referenced by TRIP-POINT, to indicate the attainment of a minimum preset threshold on the part of the boost voltage; at this point reading can be performed.

Accordingly, these two charts show the flexibility of the reading timing as a function of the level of the supply voltage.

In practice it has been obse rved that the memory architecture according to the invention fully achieves the intended aim, since it allows to perform correct reading in synchronization with the events of the read circuits.

In particular, the architecture according to the invention allows to correctly read the data item even in power supply start-up conditions, i.e., from the very start; in other words, when said power supply has not yet reached its steady-state value.

The reading achieved with the architecture according to the invention is highly immune to noise, due to the fact that only the actually completed and therefore authentic reading cycles cause switching of the output buffers 8, modifying the data in output.

The memory device has time-controlled event management, and this entails synchronization among the various internal circuits and with the essential propagations of the signals within the memory, thus providing a flexible reading timing that is dynamically adapted to the characteristics of the internal circuits determined by the technology that is used and by the power supply values that are present for the device (voltage V_{DD} or boost voltage).

The consumptions of the memory device are minimized, since activation of the memory circuits is limited only to the step for extracting the data item to be read, at the same time ensuring greater reliability of the memory device, since static biasings within the device are eliminated.

In particular, end-of-cycle deselection of the row decoders 3 allows to interrupt all tapping of current from the boost line, improving memory performance and avoiding useless overloads. Furthermore, this approach allows to completely eliminate consumptions at zero frequency and in any case provides a correlation that is directly proportional to the frequency.

The output buffers 8, being substantially immune to noise, can be given large dimensions, with the advantage of reducing the output switching times and therefore providing faster memory reading.

In conclusion, the matching of the read timing with the characteristics of the read circuits, with the power supply and temperature conditions, and with the actual propagations of the signals along the lines (determining delays that are not predefined and static but are "dynamic") allows to optimize read times, at the same time always ensuring correct reading of the data of the memory.

The architecture thus conceived is susceptible of numerous modifications and variations, all of which are within the scope of the inventive concept; all the details may furthermore be replaced with other technically equivalent elements.

In practice, the materials employed, so long as they are compatible with the specific use, as well as the dimensions, may be any according to the requirements and the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. Memory architecture for flexible reading management, particularly for non-volatile memories, comprising: at least one memory matrix (1); at least one sense amplifier (7) for capturing the data from said at least one memory matrix; and at least one output buffer (8) for providing the read data in output, said buffer being connected to said sense amplifier by means of an internal bus; and at least one row decoder (3) for selecting the word lines of said memory matrix; the memory architecture further comprising:
-- a memory read address transition detection circuit (9), adapted to produce an address transition signal (ATD);
-- a circuit (13) for enabling/disabling read circuits of the memory, said read circuits comprising word lines and bit lines of said memory matrix and said at least one row decoder;
-- a reading cycle end circuit (14), adapted to determine the end of a reading process by deactivating said row decoder (5) following the capture of the read data item in said sense amplifier (7); and
-- a circuit (15) for the synchronized and time-limited loading of the data in said at least one output buffer (8), said output buffer having a memory structure and being normally disconnected from the internal circuits, said enabling of the reading process being performed in close correlation with the intrinsic characteristics of the read circuits and of the memory cells; characerized by
-- a circuit (11) for enabling the reading process, adapted to enable reading only after the minimum working point of the memory cells involved in the reading operation and of all the connected read circuits have been reached, said minimum working point being the point when the power supply reaches a value adapted to allow the operation of said memory cells and of said read circuits; and
-- a network (12) for modulating the delay and duration of a subsequent equalization step, in close correlation to the characteristics of the memory components, to the signal propagations through said memory components, and to the conductivity of the memory cells, said propagations being detected by a propagation reproduction circuit (4, 5, 6).

2. Memory architecture according to claim 1, **characterized in that** said propagation reproduction circuit comprises a dummy word line (4) and a dummy bit line (6), which are respectively identical to a generic word line and to a generic bit line of the memory matrix, in order to reproduce the propagation times of the signals along said lines.

3. Memory architecture according to claim 1, **characterized in that** said address transition signal (ATD) is sent in input to said read circuit enabling/disabling circuit (13), to said reading process enabling circuit (11), and to said cycle end circuit (14).

4. Memory architecture according to claim 1, **characterized in that** it also comprises a circuit for the activation of said at least one output buffer (8) that is adapted to activate said output buffer simultaneously with the first read data item.

5. Memory architecture according to claim 1, **characterized in that** it furthermore comprises a circuit (25) for determining whether a preset threshold level has been reached by a boost supply voltage, said circuit being adapted to emit a signal (BOOSTok) for confirming the attainment of the minimum preset condition for said boost voltage, said signal being sent in input to said read process enabling circuit (11).

6. Memory architecture according to claim 1, **characterized in that** said read process enabling circuit (11) comprises a circuit for generating a power-on-reset signal (POR) that is adapted to determine the attainment, by the supply voltage, of a minimum level that is adapted to ensure correct data reading, said power-on-reset signal being generated as a function of the conductivity of a sample memory cell that is identical to a generic matrix cell.

7. Memory architecture according to claim 6, **characterized in that** said read process enabling circuit (11) also comprises a circuit for reproducing the selection/deselection and pre-charge delays of a generic bit line and a circuit for determining the attainment of the working point of the bit line involved in the reading operation, adapted to emit a signal for indicating interruption of the pre-charge step for said bit line, so as to determine a minimum but flexible pre-charge interval that is correlated with the characteristics of the memory device, said pre-charge interruption signal being sent in input to said network for equalization and correlation of the reading operation with respect to the characteristics of the devices and to the supply voltage value that is actually present.

8. Memory architecture according to claim 1, **characterized in that** said network (12) is adapted to emit an equalization signal (EQ), whose generation delay and slope are modulated according to the conductivity of a memory cell that is identical to a generic matrix cell and with the same biasing conditions, said equalization signal (EQ) being sent in input to said circuit (13) for enabling/disabling the read circuits.

9. Memory architecture according to claim 8, **characterized in that** said circuit (15) for the synchronized loading of the data in said at least one output buffer (8) receives in input said equalization signal (EQ) and said address transition signal (ATD), in order to generate a signal for loading the data in said at least one output buffer, after transmission over said internal bus, said synchronized data loading being provided for a minimum time interval that is sufficient for the transit and capture of the data in the memory structure of said output buffer.

10. Memory architecture according to claim 1, **characterized in that** it comprises two memory half-matrices (1_{H}, 1_{L}) and two row decoders (5_{H}, 5_{L}), one for each half-matrix.

11. Memory architecture according to claim 10, **characterized in that** at least one output buffer (8) is provided for each one of said two memory half-matrices.

12. Memory architecture according to claim 11, **characterized in that** said circuit (15) for the synchronized loading of the data in said output buffers has means for selecting the loading of the data that arrive from one of said two memory half-matrices and the other.

13. Memory architecture according to claim 1, **characterized in that** said row decoder (5) is a hierarchical decoder.

14. Method for reading data of a memory device, particularly of the non-volatile type, that comprises: at least one memory matrix; at least one sense amplifier for capturing the data from said at least one memory matrix; at least one output buffer for providing the read data in output, said buffer being connected to said sense amplifier by means of an internal bus; and at least one row decoder for selecting the word lines of said memory matrix; comprising the steps of:
-- selecting a row of the memory matrix that corresponds to a read address and generating a read address transition detection signal for the synchronization of the read circuits, said read circuits comprising word lines and bit lines and said at least one row decoder;
-- modulating the delay and duration of a subsequent equalization step, in close correlation to the characteristics of the memory components, to the signal propagations through said memory components, and to the conductivity of the memory cells, said propagations being detected by a propagation reproduction circuit;
-- determining when the conditions of minimum functionality for the read circuits, for the memory cells to be read, and for the supply voltage are attained;
-- enabling the read circuits exclusively for the reading step;
-- capturing the data of the memory matrix in said at least one sense amplifier; and
-- sending said data to said at least one output buffer, synchronously with the arrival of the data, to provide them in output.

15. Reading method according to claim 14, **characterized in that** it comprises the additional step of determining when a boost voltage reaches a preset minimum threshold level, in order to trigger the reading process.

16. Reading method according to claim 14, **characterized in that** it comprises the additional step of enabling said at least one output buffer simultaneously with said first read data item.

17. Reading method according to claim 14, **characterized in that** said step of determining whether the minimum functionality conditions for the read circuits, for the memory cells to be read, and for the supply voltage have been reached consists in reproducing the propagations of word lines and bit lines selected in said memory matrix in order to reproduce their delays, detect the attainment of a minimum supply voltage level to perform correct reading of the data of the matrix, and generate an equalization signal that is correlated to the conductivity of the memory cells to be read, to the propagations, and to the operating voltage.

18. Reading method according to claim 14, **characterized in that** said step for capturing the read data in the sense amplifier is performed simultaneously with a step for deactivating the row decoder to limit the consumptions of the memory device.

19. Reading method according to claim 14, **characterized in that** the step of sending the read data to said at least one output buffer comprises the step of loading said data in the output buffer synchronously with the arrival of the data and for a time interval that is sufficient for the transit and capture of the data in said output buffer.

20. Reading method according to claim 14, **characterized in that** it comprises the additional step of disconnecting said output buffer from the other read circuits following the loading of the data within said output buffer, the content of the output buffer being updated only at the end of a complete reading cycle.

## Patentansprüche

1. Speicherarchitektur für flexible Leseverwaltung, insbesondere für nichtflüchtige Speicher, mit: zumindest einer Speichermatrix (1 ); zumindest einem Leseverstärker (7) zum Erfassen der Daten aus der zumindest einen Speichermatrix; und zumindest einem Ausgangspuffer (8) zum Bereitstellen der geles e-nen Daten am Ausgang, wobei der Puffer mittels eines internen Busses mit dem Leseverstärker verbunden ist; und zumindest einem Zeilendecoder (3) zum Auswählen der Wortleitungen der Speichermatrix; wobei die Speicherarchitektur des weiteren umfasst:
-- eine Speicherleseadressenübergangs-Erfassungsschaltung (9) ausgestaltet zur Erzeugung eines Adressenübergangssignals (ATD);
-- eine Schaltung (13) zum Freigeben/Sperren von Leseschaltungen des Speichers, wobei die Leseschaltungen Wortleitungen und Bitleitungen der Speichermatrix und den zumindest einen Zeilendecoder umfassen;
-- eine Lesezyklusendeschaltung (14) ausgestaltet zur Bestimmung des Endes eines Lesevorgangs durch Deaktivieren des Zeilendecoders (5) nach der Erfassung des gelesenen Datenelements in dem Leseverstärker (7); und
-- eine Schaltung (15) für das synchronisierte und zeitbegrenzte Laden der Daten in den zumindest einen Ausgangspuffer (8), wobei der Ausgangspuffer eine Speicherstruktur aufweist und normalerweise von den internen Schaltungen abgetrennt ist, wobei die Freigabe des Lesevorgangs in enger Korrelation mit den intrinsischen Eigenschaften der Leseschaltungen und der Speicherzellen durchgeführt wird; **gekennzeichnet durch**
-- eine Schaltung (11) zum Freigeben des Lesevorgangs, ausgestaltet zur Freigabe des Lesens ausschließlich nach dem Erreichen des minimalen Arbeitspunkts der in der Leseoperation involvierten Speicherzellen und aller angeschlossenen Leseschaltungen, wobei der minimale Arbeitspunkt denjenigen Punkt darstellt, an dem die Stromversorgung einen zur Ermöglichung des Betriebs der Speicherzellen und der Leseschaltungen angepassten Wert erreicht hat; und
-- ein Netzwerk (12) zum Modulieren der Verzögerung und Dauer eines darauffolgenden Angleichungsschritts, in enger Korrelation mit den Eigenschaften der Speicherkomponenten, mit den Signalausbreitungen **durch** die Speicherkomponenten und mit der Leitfähigkeit der Speicherzellen, wobei die Ausbreitungen erfasst werden **durch** eine Ausbreitungswiedergabeschaltung (4, 5, 6).

2. Speicherarchitektur nach Anspruch 1, **dadurch gekennzeichnet, dass** die Ausbreitungswiedergabeschaltung eine Pseudowortleitung (4) und eine Pseudobitleitung (6) aufweist, die jeweils identisch mit einer generischen Wortleitung und einer generischen Bitleitung der Speichermatrix sind, um die Ausbreitungszeiten der Signale entlang der Leitungen wiederzugeben.

3. Speicherarchitektur nach Anspruch 1, **dadurch gekennzeichnet, dass** das Adressenübergangssignal (ATD) zum Eingang der Leseschaltungsfreigabe/Sperrschaltung (13), der Lesevorgangsfreigabeschaltung (11) und der Zyklusendeschaltung (14) gesendet wird.

4. Speicherarchitektur nach Anspruch 1, **dadurch gekennzeichnet, dass** diese auch eine Schaltung umfasst für die Aktivierung des zumindest einen Ausgangspuffers (8), die ausgestaltet ist zum Aktivieren des Ausgangspuffers zeitgleich mit dem ersten gelesenen Datenelement.

5. Speicherarchitektur nach Anspruch 1, **dadurch gekennzeichnet, dass** diese des weiteren eine Schaltung (25) umfasst zum Bestimmen ob ein voreingestellter Schwellwert durch eine angehobene Versorgungsspannung erreicht wurde, wobei die Schaltung ausgestaltet ist zum Aussenden eines Signals (BOOSTok) zum Bestätigen des Erreichens der minimalen voreingestellten Bedingung für die angehobene Spannung, wobei das Signal als Eingabe zu der Lesevorgangsfreigabeschaltung (11 ) gesendet wird.

6. Speicherarchitektur nach Anspruch 1, **dadurch gekennzeichnet, dass** die Lesevorgangsfreigabeschaltung (11 ) eine Schaltung umfasst zum Erzeugen eines Einschaltrücksetzsignals (POR), das ausgestaltet ist zur Bestimmung des Erreichens, durch die Versorgungsspannung, eines minimalen Pegels, der ausgestaltet ist zum Sicherstellen eines korrekten Datenlesens, wobei das Einschaltrücksetzsignal als Funktion der Leitfähigkeit einer Probespeicherzelle, die identisch ist zu einer generischen Matrixzelle, erzeugt wird.

7. Speicherarchitektur nach Anspruch 6, **dadurch gekennzeichnet, dass** die Lesevorgangsfreigabeschaltung (11 ) auch eine Schaltung umfasst zum Widergeben der Auswahl/Endwahl- und Vorladeverzögerungen einer generischen Bitleitung und eine Schaltung zum Bestimmen des Erreichens des Arbeitspunkts der bei der Leseoperation involvierten Bitleitung, ausgestaltet zum Aussenden eines Signals zum Anzeigen einer Unterbrechung des Vorladeschritts für die Bitleitung, um ein minimales aber flexibles Vorladeintervall zu bestimmen, das korreliert ist mit den Eigenschaften der Speichervorrichtung, wobei das Vorladeunterbrechungssignal als Eingabe in das Netzwerk gesendet wird zur Angleichung und Korrelation der Leseoperation bezüglich der Eigenschaften der Vorrichtungen und des aktuell vorliegenden Versorgungsspannungswerts.

8. Speicherarchitektur nach Anspruch 1, **dadurch gekennzeichnet, dass** das Netzwerk (12) ausgestaltet ist zum Aussenden eines Angleichungssignals (EQ), dessen Erzeugungsverzögerung und Anstieg moduliert sind entsprechend der Leitfähigkeit einer Speicherzelle, die identisch ist zu einer generischen Matrixzelle und dieselben Vorspannungsbedingungen aufweist, wobei das Angleichungssignal (EQ) als Eingabe in die Schaltung (13) gesendet wird zur Freigabe/Sperrung der Leseschaltungen.

9. Speicherarchitektur nach Anspruch 8, **dadurch gekennzeichnet, dass** die Schaltung (15) für das synchronisierte Laden der Daten in den zumindest einen Ausgangspuffer (8) das Angleichungssignal (EQ) und das Adressenübergangssignal (ATD) als Eingabe empfängt, um ein Signal zum Laden der Daten in den zumindest einen Ausgangspuffer zu erzeugen, nach der Übertragung über den internen Bus, wobei das synchronisierte Datenladen für ein minimales Zeitintervall bereitgestellt ist, das ausreichend ist für den Durchgang und das Erfassen der Daten in der Speicherstruktur des Ausgangspuffers.

10. Speicherarchitektur nach Anspruch 1, **dadurch gekennzeichnet, dass** diese zwei Speicherhalbmatrizen (1_{H}, 1_{L}) und zwei Zeilendecoder (5_{H}, 5_{L}) aufweist, jeweils einer für jede Halbmatrix.

11. Speicherarchitektur nach Anspruch 10, **dadurch gekennzeichnet, dass** zumindest ein Ausgangspuffer (8) für jede der beiden Speicherhalbmatrizen bereitgestellt ist.

12. Speicherarchitektur nach Anspruch 11, **dadurch gekennzeichnet, dass** die Schaltung (15) für das synchronisierte Laden der Daten in die Ausgangspuffer eine Einrichtung aufweist zum Auswählen des Ladens der von einer der beiden Speicherhalbmatrizen und der anderen ankommenden Daten.

13. Speicherarchitektur nach Anspruch 1, **dadurch gekennzeichnet, dass** der Zeilendecoder (5) ein hierarchischer Decoder ist.

14. Verfahren zum Lesen von Daten einer Speichervorrichtung, insbesondere des nichtflüchtigen Typs, die umfasst: zumindest eine Speichermatrix; zumindest einen Leseverstärker zum Erfassen der Daten von der zumindest einen Speichermatrix; zumindest einen Ausgangspuffer zum Bereitstellen der gelesenen Daten am Ausgang, wobei der Puffer mittels eines internen Busses mit dem Leseverstärker verbunden ist; und zumindest einen Zeilendecoder zum Auswählen der Wortleitungen der Speichermatrix; mit den Schritten:
-- Auswählen einer der Leseadresse entsprechenden Zeile der Speichermatrix und Erzeugen eines Leseadressenübergang-Erfassungssignals für die Synchronisation der Leseschaltungen, wobei die Leseschaltungen Wortleitungen und Bitleitungen und den zumindest einen Zeilendecoder aufweisen;
-- Modulieren der Verzögerung und Dauer eines nachfolgenden Angleichungsschritts, in enger Korrelation mit den Eigenschaften der Speicherkomponenten, mit den Signalausbreitungen durch die Speicherkomponenten und mit der Leitfähigkeit der Speicherzellen, wobei die Ausbreitungen durch eine Ausbreitungswiedergabeschaltung erfasst werden;
-- Feststellen, wann die Bedingungen einer minimalen Funktionalität für die Leseschaltungen, für die zu lesenden Speicherzellen und für die Versorgungsspannung erreicht sind;
-- Freigeben der Leseschaltungen ausschließlich für den Leseschritt;
-- Erfassen der Daten der Speichermatrix in dem zumindest einen Leseverstärker; und
-- Senden der Daten zu dem zumindest einen Ausgangspuffer, synchron zu der Ankunft der Daten, um sie am Ausgang bereitzustellen.

15. Leseverfahren nach Anspruch 14, **dadurch gekennzeichnet, dass** es den zusätzlichen Schritt umfasst des Bestimmens, wann eine angehobene Spannung einen voreingestellten minimalen Schwellwert erreicht, um den Lesevorgang anzustossen.

16. Leseverfahren nach Anspruch 14, **dadurch gekennzeichnet, dass** es den zusätzlichen Schritt umfasst des Freigebens des zumindest einen Ausgangspuffers zeitgleich mit dem ersten gelesenen Datenelement.

17. Leseverfahren nach Anspruch 14, **dadurch gekennzeichnet, dass** der Schritt des Bestimmens, wann die minimalen Funktionalitätsbedingungen für die Leseschaltungen, für die zu lesenden Speicherzellen und für die Versorgungsspannung erreicht wurden, besteht aus dem Wiedergeben der Ausbreitungen von in der Speichermatrix ausgewählten Wortleitungen und Bitleitung, um deren Verzögerungen wiederzugeben, das Erreichen eines minimalen Versorgungsspannungspegels zur Durchführung eines korrekten Lesens der Daten der Matrix zu erfassen, und ein Angleichungssignal zu erzeugen, das korreliert ist mit der Leitfähigkeit der zu lesenden Speicherzellen, mit den Ausbreitungen, und mit der Betriebsspannung.

18. Leseverfahren nach Anspruch 14, **dadurch gekennzeichnet, dass** der Schritt des Erfassens der gelesenen Daten in dem Leseverstärker zeitgleich durchgeführt wird mit einem Schritt zum Deaktivieren des Zeilendecoders, um die Verbräuche der Speichervorrichtung zu begrenzen.

19. Leseverfahren nach Anspruch 14, **dadurch gekennzeichnet, dass** der Schritt des Sendens der gelesenen Daten zu dem zumindest einen Ausgangspuffer den Schritt umfasst des Lesens der Daten in dem Ausgangpuffer synchron zu der Ankunft der Daten und während eines Zeitintervalls, das ausreichend ist für den Durchgang und die Erfassung der Daten in dem Ausgangspuffer.

20. Leseverfahren nach Anspruch 14, **dadurch gekennzeichnet, dass** es den zusätzlichen Schritt umfasst des Abtrennens des Ausgangspuffers von den anderen Leseschaltungen nach dem Laden der Daten innerhalb des Ausgangspuffers, wobei der Inhalt des Ausgangspuffers nur am Ende eines kompletten Lesezyklus aktualisiert wird.

## Revendications

1. Architecture de mémoire pour gestion flexible de lecture, en particulier pour mémoires non volatiles, comprenant au moins une matrice mémoire (1), au moins un amplificateur de lecture (7) pour capter les données à partir de ladite au moins une matrice mémoire, et au moins un tampon de sortie (8) pour fournir les données lues en sortie, ledit tampon étant connecté à l'amplificateur de lecture au moyen d'un bus interne ; et au moins un décodeur de rangée (3) pour sélectionner les lignes de mots de la matrice mémoire ; l'architecture de mémoire comprenant en outre :
- un circuit de détection de transition d'adresse de lecture mémoire (9) adapté à produire un signal de transition d'adresse (ATD) ;
- un circuit (13) pour valider et invalider les circuits de lecture de la mémoire, les circuits de lecture comprenant des lignes de mots et des lignes de bits de la matrice mémoire et ledit au moins un décodeur de rangées :
- un circuit (14) de fin de cycle de lecture adapté à déterminer la fin d'un processus de lecture en désactivant le décodeur de rangées (5) après la capture de l'élément de données lu dans l'amplificateur de lecture (7) ; et
- un circuit (15) pour le chargement synchronisé et limité dans le temps de la donnée dans ledit au moins un tampon de sortie (8), le tampon de sortie ayant une structure de mémoire et étant normalement déconnecté des circuits internes, la validation du processus de lecture étant réalisée en étroite corrélation avec les caractéristiques intrinsèques des circuits de lecture et des cellules mémoire ; **caractérisé par** :
un circuit (11) pour valider le processus de lecture adapté à valider la lecture seulement après que le point de fonctionnement minimum des cellules mémoire impliquées dans l'opération de lecture et de tous les circuits de lecture connectés a été atteint, le point de fonctionnement minimum étant le point pour lequel l'alimentation atteint une valeur adaptée à permettre le fonctionnement des cellules mémoire et des circuits de lecture ; et
un circuit (12) pour moduler le retard et la durée d'une étape d'égalisation ultérieure, en étroite corrélation avec les caractéristiques des éléments de mémoire, avec les propagations de signal dans les éléments de mémoire, et avec la conductivité des cellules mémoire, lesdites propagations étant détectées par un circuit de reproduction de propagation (4, 5, 6).

2. Architecture de mémoire selon la revendication 1, **caractérisée en ce que** le circuit de reproduction de propagation comprend une ligne de mots témoin (4) et une ligne de bits témoin (6), qui sont respectivement identiques à une ligne de mots générique et à une ligne de bits générique de la matrice mémoire, pour reproduire les durées de propagation des signaux le long de ces lignes.

3. Architecture de mémoire selon la revendication 1, **caractérisée en ce que** le signal de transition d'adresse (ATD) est envoyé en entrée au circuit (13) de validation/invalidation du circuit de lecture, au circuit (11) de validation du processus de lecture, et au circuit (14) de fin de cycle.

4. Architecture de mémoire selon la revendication 1, **caractérisée en ce qu'**elle comprend également un circuit pour l'activation dudit au moins un tampon de sortie (8) qui est adapté à activer le tampon de sortie en même temps que le premier élément de données lues.

5. Architecture de mémoire selon la revendication 1, **caractérisée en ce qu'**elle comprend en outre un circuit (25) pour déterminer si un niveau de seuil prédéterminé a été atteint par une tension d'alimentation surélevée, le circuit étant adapté à émettre un signal (BOOSTok) pour confirmer le fait que l'on a atteint l'état prédéterminé minimum pour la tension surélevée, le signal étant envoyé en entrée au circuit (11) de validation de processus de lecture.

6. Architecture de mémoire selon la revendication 1, **caractérisée en ce que** le circuit (11) de validation de processus de lecture comprend un circuit pour produire un signal de remise à zéro à la mise sous tension (POR) qui est adapté à déterminer le fait que la tension d'alimentation a atteint un niveau minimum adapté à assurer une lecture de données correcte, le signal de remise à zéro à la mise sous tension étant produit en fonction de la conductivité d'une cellule mémoire échantillon qui est identique à une cellule générique de la matrice mémoire.

7. Architecture de mémoire selon la revendication 6 , **caractérisée en ce que** le circuit (11) de validation de processus de lecture comprend également un circuit pour reproduire les retards de sélection/désélection et de précharge d'une ligne de bits générique et un circuit pour déterminer le fait que l'on a atteint le point de fonctionnement de la ligne de bits impliquée dans l'opération de lecture, adapté à émettre un signal pour indiquer l'interruption de l'étape de précharge pour la ligne de bits, de façon à déterminer un intervalle de précharge minimum et flexible qui est corrélé avec les caractéristiques du dispositif mémoire, le signal d'interruption de précharge étant envoyé audit circuit d'égalisation et de corrélation de l'opération de lecture par rapport aux caractéristiques des dispositifs et à la valeur courante de la tension d'alimentation.

8. Architecture de mémoire selon la revendication 1, **caractérisée en ce que** ledit circuit (12) est adapté à émettre un signal d'égalisation (EQ), dont le retard et la pente de génération sont modulés selon la conductivité d'une cellule mémoire qui est identique à une cellule générique de la matrice et avec les mêmes conditions de polarisation, le signal d'égalisation (EQ) étant envoyé à l'entrée du circuit (13) de validation/invalidation des circuits de lecture.

9. Architecture de mémoire selon la revendication 8, **caractérisée en ce que** ledit circuit (15) pour le chargement synchronisé des données dans ledit au moins un tampon de sortie (8) reçoit le signal d'égalisation (EQ) et le signal de transition d'adresse (ATD) pour produire un signal de chargement de données dans ledit au moins un tampon de sortie, après émission sur le bus interne, le chargement de données synchronisé étant assuré pendant une durée minimum suffisante pour le transit et la capture des données dans la structure mémoire du tampon de sortie.

10. Architecture de mémoire selon la revendication 1, **caractérisée en ce qu'**elle comprend deux demi-matrices mémoire (1_{H}, 1_{L}) et deux décodeurs de rangée (5_{H}, 5_{L}), un pour chaque demi-matrices.

11. Architecture de mémoire selon la revendication 10, **caractérisée en ce que** ledit au moins un tampon de sortie (8) est prévu pour chacune des deux demi-matrices mémoire.

12. Architecture de mémoire selon la revendication 11, **caractérisée en ce que** le circuit (15) pour le chargement synchronisé des données dans les tampons de sortie comporte des moyens pour sélectionner le chargement des données qui arrive à partir de l'une des deux demi-matrices mémoire et de l'autre.

13. Architecture de mémoire selon la revendication 1, **caractérisée en ce que** le décodeur de rangée (5) est un décodeur hiérarchique.

14. Procédé de lecture de données d'un dispositif mémoire, en particulier du type non volatile, qui comprend au moins une matrice mémoire, au moins un amplificateur de lecture pour capter les données à partir de ladite au moins une matrice mémoire, au moins un tampon de sortie pour fournir les données lues, le tampon étant connecté à un amplificateur de lecture par un bus interne, et au moins un décodeur de rangée pour sélectionner une ligne de mots de la matrice mémoire, comprenant les étapes suivantes :
- sélectionner une rangée de la matrice mémoire qui correspond à une adresse lue et produire un signal de détection de transition d'adresse lue pour la synchronisation des circuits de lecture, les circuits de lecture comprenant des lignes de mots et des lignes de bits et ledit au moins un décodeur de rangée ;
- moduler le retard et la durée d'une étape d'égalisation ultérieure en étroite corrélation avec les caractéristiques des éléments de mémoire, avec les propagations de signal dans les éléments de mémoire, et avec la conductivité des cellules mémoire, les propagations étant détectées par un circuit de reproduction de propagation ;
- déterminer quand les conditions d'une fonctionnalité minimum des circuits de lecture pour les cellules mémoire à lire et pour la tension d'alimentation sont atteintes ;
- valider les circuits de lecture exclusivement pendant l'étape de lecture ;
- capter les données de la matrice mémoire dans ledit au moins un amplificateur de lecture ; et
- envoyer les données vers ledit au moins un tampon de sortie, de façon synchrone avec l'arrivée des données, pour les fournir en sortie.

15. Procédé de lecture selon la revendication 14, **caractérisé en ce qu'**il comprend l'étape supplémentaire consistant à déterminer quand une tension surélevée atteint un niveau de seuil minimum prédéterminé pour déclencher le processus de lecture.

16. Procédé de lecture selon la revendication 14, **caractérisé en ce qu'**il comprend une étape supplémentaire consistant à valider ledit au moins un tampon de sortie simultanément avec le premier élément de données lues.

17. Procédé de lecture selon la revendication 14, **caractérisé en ce que** l'étape de détermination du fait que les conditions de fonctionnalité minimum pour les circuits de lecture, pour les cellules mémoire à lire et pour la tension d'alimentation ont été atteintes consiste à reproduire les propagations de lignes de mots et de lignes de bits choisies dans la matrice mémoire pour reproduire leurs retards, détecter le fait que l'on atteint le niveau de tension d'alimentation minimum pour réaliser une lecture correcte des données de la matrice, et produire un signal d'égalisation corrélé avec la conductivité des cellules mémoire à lire, avec les propagations, et avec la tension de fonctionnement.

18. Procédé de lecture selon la revendication 14, **caractérisé en ce que** l' étape de capture des données lues dans l'amplificateur de lecture est réalisée en même temps que l'étape de désactivation du décodeur de rangée pour éviter la consommation du dispositif mémoire.

19. Procédé de lecture selon la revendication 14, **caractérisé en ce que** l'étape d'envoi des données lues vers ledit au moins un tampon de sortie comprend l'étape consistant à charger les données dans le tampon de sortie en synchronisme avec l'arrivée des données et pendant un intervalle de temps suffisant pour le transit et la capture des données dans le tampon de sortie.

20. Procédé de lecture selon la revendication 14, **caractérisé en ce qu'**il comprend l'étape supplémentaire de déconnexion du tampon de sortie des autres circuits de lecture après le chargement des données dans le tampon de sortie, le contenu du tampon de sortie étant mis à jour seulement à la fin d'un cycle de lecture complet.
